# EUROPÄISCHE PATENTSCHRIFT

(11) **EP 2 294 599 B1**
(45) Veröffentlichungstag und Bekanntmachung des Hinweises auf die Patenterteilung: **03.09.2014**
(21) Anmeldenummer: 09749633.5
(22) Anmeldetag: 20.05.2009
(51) Int. Cl.: H01J 37/32, C23C 14/04, B05D 7/24, B29C 59/14

(54) **PLASMASTEMPEL, PLASMABEHANDLUNGSVORRICHTUNG, VERFAHREN ZUR PLASMABEHANDLUNG UND HERSTELLUNGSVERFAHREN FÜR EINEN PLASMASTEMPEL**
PLASMA STAMP, PLASMA TREATMENT DEVICE, METHOD FOR PLASMA TREATMENT AND METHOD FOR PRODUCING A PLASMA STAMP
POINÇON À PLASMA, DISPOSITIF DE TRAITEMENT AU PLASMA, PROCÉDÉ DE TRAITEMENT AU PLASMA ET PROCÉDÉ DE FABRICATION D'UN POINÇON À PLASMA

(30) Priorität: 21.05.2008 DE 102008024486
(43) Veröffentlichungstag der Anmeldung: 16.03.2011
(73) Patentinhaber: Fraunhofer-Gesellschaft zur Förderung der angewandten Forschung e.V., 80686 München (DE)
(72) Erfinder: KLAGES, Claus-Peter, 38102 Braunschweig (DE); THOMAS, Michael, 31275 Lehrte (DE)
(86) Internationale Anmeldenummer: PCT/EP2009/003615
(87) Internationale Veröffentlichungsnummer: WO 2009/141143

(56) Entgegenhaltungen:
- WO-A-01/69644
- DE-B3- 10 322 696
- KREITZ ET AL: "Patterned DBD treatment for area-selective metallization of polymers-plasma printing" SURFACE AND COATINGS TECHNOLOGY, ELSEVIER, AMSTERDAM, NL, Bd. 200, Nr. 1-4, 1. Oktober 2005 (2005-10-01), Seiten 676-679, XP005063600 ISSN: 0257-8972
- PENACHE C ET AL: "Plasma printing: patterned surface functionalisation and coating at atmospheric pressure - MICRO.tec 2003" 20040802, Bd. 151, Nr. 4, 2. August 2004 (2004-08-02), Seiten 139-144, XP006022579
- Plasma Processes and Polymers Wiley-VCH Germany, Bd. 4, Nr. 3, 2007, Seiten 208-218, XP002544450 ISSN: 1612-8850 & DATABASE INSPEC [Online] THE INSTITUTION OF ELECTRICAL ENGINEERS, STEVENAGE, GB; 23. April 2007 (2007-04-23), KLAGES C P ET AL: "Surface technology with cold microplasmas" Database accession no. 9578613

## Beschreibung

Die Erfindung betrifft einen Plasmastempel, mit welchem Oberflächen einer Plasmabehandlung unterzogen werden können. Die Erfindung betrifft außerdem eine Plasmabehandlungsvorrichtung, mit welcher Oberflächen einer Plasmabehandlung unterzogen werden können, sowie ein Plasmabehandlungsverfahren. Die Erfindung betrifft außerdem ein Verfahren zur Herstellung eines Plasmastempels.

Für viele Anwendungen ist es erwünscht, eine Oberfläche einer ortsaufgelösten bzw. ortsselektiven Plasmabehandlung unterziehen zu können. Hierbei sollen bestimmte Bereiche der Oberfläche einem Plasma ausgesetzt werden, während andere Bereiche der Oberfläche dem Plasma nicht ausgesetzt werden.

Eine solche ortsselektive Plasmabehandlung kann mit Plasmastempeln durchgeführt werden, die eine Oberfläche mit einer oder mehreren, vorzugsweise einer Vielzahl von Kavitäten aufweisen. In diesen Kavitäten kann ein Plasma erzeugt werden. Zur ortsselektiven Plasmabehandlung einer Oberfläche wird der Plasmastempel mit jener die Kavitäten aufweisenden Oberfläche auf die zu behandelnde Oberfläche aufgelegt oder aufgedrückt. Die zu behandelnde Oberfläche wird nur dort dem Plasma ausgesetzt, wo sie bei aufgelegtem Plasmastempel an eine der Kavitäten grenzt. Durch die Anordnung oder Aktivierung der Kavitäten im Plasmastempel kann bestimmt werden, welche Bereiche der zu behandelnden Oberfläche einem Plasma ausgesetzt und damit einer Plasmabehandlung unterzogen werden.

Eine Vorrichtung zur Durchführung eines solchen Plasmabehandlungsverfahrens ist beispielsweise in der EP 1 264 330 B1 beschrieben. Hier sind in einem Plasmastempel geschlossene Volumina angeordnet, in welchen das Plasma gezündet wird. Nachteilig bei einer solchen Anordnung ist jedoch, dass den Kavitäten kein Gas zu- oder abgeführt werden kann und dass kein Druckausgleich in den Kavitäten möglich ist. Dies ist insbesondere dann relevant, wenn die Plasmabehandlung ein Beschichtungsverfahren ist, in welchem eine Beschichtung auf die zu behandelnde Oberfläche aufgebracht werden soll. In diesem Falle verbraucht sich nämlich das Plasmagas. Die Dicke der herstellbaren Schicht wird also durch das in den Kavitäten vorhandene Gasvolumen begrenzt. Beschichtungen größerer Dicke sind daher mit einer solchen Vorrichtung nicht herstellbar.

Aufgabe der vorliegenden Erfindung ist es daher, einen Plasmastempel und eine Plasmabehandlungsvorrichtung anzugeben, bei welchem die in einem Plasmabeschichtungsverfahren erzeugbare Schichtdicke nicht durch das Volumen der Kavitäten begrenzt ist und auch andere Verfahren unabhängig von sich verbrauchendem Plasmagas durchgeführt werden können. Aufgabe der vorliegenden Erfindung ist es außerdem, ein Verfahren zur Plasmabehandlung anzugeben, mit welchem diese Vorteile realisierbar sind. Auch ist es Aufgabe der Erfindung, ein Verfahren zur Herstellung eines entsprechenden Plasmastempels anzugeben.

Die Aufgaben werden gelöst durch den Plasmastempel nach Anspruch 1, die Plasmabehandlungsvorrichtung nach Anspruch 9, das Verfahren zur Plasmabehandlung nach Anspruch 11 und das Verfahren zur Herstellung eines Plasmastempels nach Anspruch 13. Vorteilhafte Weiterbildungen des Plasmastempels, der Plasmabehandlungsvorrichtung, des Verfahrens zur Plasmabehandlung und des Verfahrens zur Herstellung eines Plasmastempels werden durch die jeweiligen abhängigen Ansprüche gegeben.

Ein erfindungsgemäßer Plasmastempel weist eine Gasleitschicht auf, welche zumindest ein poröses Material aufweist oder daraus besteht. Der erfindungsgemäße Plasmastempel weist außerdem zumindest eine Kavität auf, welche mit der Gasleitschicht in gasdurchlässiger Verbindung steht und welche eine Öffnung zu einer Unterseite des Plasmastempels aufweist. Erfindungsgemäß ist nun der Plasmastempel so ausgestaltet, dass Gas im Bereich hinter der Öffnung der Kavität in Richtung im Wesentlichen parallel zur Fläche der Öffnung durch die Gasleitschicht leitbar ist. Der Bereich hinter der Öffnung ist jener Bereich im Inneren des Plasmastempels, vor welchem die Öffnung der Kavität in der Unterseite angeordnet ist. Dieser Bereich kann die Kavität selbst umfassen sowie auch aus Sicht von der Unterseite des Plasmastempels hinter der Kavität liegende Bereiche im Inneren des Plasmastempels. Der Bereich hinter der Öffnung der Kavität ist also vorzugsweise zumindest ein Teilbereich jenes Bereiches, welcher durch eine Grenzfläche umfasst wird, deren eine Kante der Rand der Öffnung der Kavität in der Unterseite ist. Vorzugsweise steht diese Grenzfläche senkrecht auf der Unterseite des Plasmastempels. Weist der Plasmastempel mehrere Schichten auf, so kann der Bereich hinter der Öffnung nur jene Schicht umfassen, in welcher die Kavität angeordnet ist, er kann auch nur jene Schicht umfassen, welche jener Schicht, in welcher die Kavität angeordnet ist, benachbart liegt oder er kann beide oder alle Schichten umfassen.

Gas ist also im Inneren des Plasmastempels an der Öffnung der Kavität vorbeileitbar. Das Gas wird hierbei im Wesentlichen oder genau parallel zur Fläche der Öffnung an dieser vorbeigeleitet. Das Gas kann hierbei direkt durch die Kavität durch deren Seitenwände hindurchströmen, es ist aber auch möglich, dass das Gas an jener der Öffnung der Kavität gegenüberliegenden Stirnseite der Kavität vorbeiströmt.

Durch die erfindungsgemäße Anordnung ist es möglich, der Kavität Gas zuzuführen, so dass verbrauchtes Gas in die Kavität nachgefüllt werden kann und/oder dass Gas in der Kavität ausgetauscht werden kann. Bevorzugterweise ist Gas der Kavität über die Gasleitschicht zuführbar und auch über die Gasleitschicht aus der Kavität ableitbar.

Die Kavität kann in der Gasleitschicht, selbst angeordnet sein. In diesem Fall ist es möglich, dass die Gasleitschicht bis zu einer bestimmten Tiefe senkrecht zur Unterseite des Plasmastempels von der Kavität durchstoßen wird. Vorzugsweise ist hinter der Kavität ebenfalls die Gasleitschicht angeordnet und wird dort nicht von Kavitäten durchstoßen.

Die Kavität kann auch in einer eigenen Kavitätsschicht angeordnet sein, wobei vorzugsweise die Kavität eine Öffnung auf der Oberseite der Kavitätsschicht aufweist und eine dieser gegenüberliegende Öffnung auf der Unterseite der Kavitätsschicht aufweist. Die Kavität durchstößt also vorzugsweise die Kavitätsschicht. Vorzugsweise ist in dieser Anordnung die Unterseite der Kavitätsschicht identisch mit der Unterseite des Plasmastempels, so dass die Öffnung auf der Unterseite der Kavitätsschicht die oben genannte Öffnung zur Unterseite des Plasmastempels ist.

Die Gasleitschicht ist in dieser Anordnung vorzugsweise an die Kavitätsschicht angrenzend derart angeordnet, dass die Gasleitschicht an die Öffnung der Kavität an die Oberseite der Kavitätsschicht angrenzt und/oder das Gas in Richtung im Wesentlichen parallel zur Fläche der Öffnung der Kavität auf der Oberseite der Kavitätsschicht an der Öffnung vorbei durch die Gasleitschicht leitbar ist. Auf diese Weise kann Gas hauptsächlich diffusiv in Richtung senkrecht zur Unterseite des Plasmastempels in die Kavität eingebracht werden. In Richtung parallel zur Unterseite des Plasmastempels oder zur Fläche, in welcher sich die Gasleitschicht oder die Konvektionsschicht flächig ausdehnen, kann der Gastransport vorzugsweise hauptsächlich konvektiv erfolgen.

Besonders vorteilhaft kann der Gasfluss in einem solchen Plasmastempel eingestellt werden, wenn die Gasleitschicht parallel zur Kavitätsschicht angeordnet ist.

Der Plasmastempel weist eine im Wesentlichen gasundurchlässige Schicht auf, welche auf jener der Unterseite des Plasmastempels abgewandten Seite der Gasleitschicht, vorzugsweise auf Seitenwänden der Gasleitschicht oder des Plasmastempels oder auch auf der Unterseite des Plasmastempels angeordnet sein kann. Mittels einer solchen gasundurchlässigen Schicht lässt sich das Gas besonders günstig in der Gasleitschicht in Richtung parallel zur Unterseite des Plasmastempels leiten. Durch eine solche Schicht kann verhindert werden, dass Gas über jene der Unterseite des Plasmastempels abgewandte Oberseite der Gasleitschicht oder über andere Oberflächen des Plasmastempels aus der Gasleitschicht entweicht. Vorteilhafterweise kann die gasundurchlässige Schicht auch die anderen Seiten des Plasmastempels, welche nicht die Unterseite sind, überdecken. Insbesondere ist es außerdem vorteilhaft, wenn die gasundurchlässige Schicht zumindest eine Öffnung zur Gaszuleitung und/oder zumindest eine Öffnung zur Gasableitung aufweist. Derartige Öffnungen können in einer oder mehrerer der Seitenwände zwischen der Oberseite und der Unterseite des Plasmastempels angeordnet sein, sie können besonders vorteilhaft aber auch beide in jener der Unterseite abgewandten Oberseite des Plasmastempels angeordnet sein.

Der Plasmastempel weist vorzugsweise eine Elektrode auf, mit welcher zusammen mit einer Elektrode einer Plasmabehandlungsvorrichtung ein elektrisches Feld erzeugbar ist. Eine solche Elektrode kann auf jener der Unterseite des Plasmastempels abgewandten Seite der Gasleitschicht angeordnet sein. Dies kann auch die Oberfläche des Plasmastempels sein. Die Elektrode ist vorzugsweise flächig ausgestaltet und kann die entsprechende Fläche teilweise oder vollständig überdecken.

Die Elektrode kann auch auf jener der Gasleitschicht oder dem Plasmastempel abgewandten Seite der gasundurchlässigen Schicht angeordnet sein. Wiederum kann die Elektrode flächig ausgedehnt sein und die entsprechende Fläche vollständig oder teilweise überdecken.

Es ist darüberhinaus auch möglich, dass die gasundurchlässige Schicht selbst eine Elektrode ist oder als Elektrode arbeitet. Hierzu ist die gasundurchlässige Schicht vorzugsweise aus einem elektrisch leitfähigen Material, beispielsweise einem Metall, hergestellt. Darüberhinaus kann auch die Gasleitschicht selbst eine Elektrode sein oder als Elektrode arbeiten, wozu diese vorzugsweise aus einem leitfähigen Material hergestellt ist.

Für die Kavität kommen grundsätzlich alle Hohlformen in Frage. Besonders vorteilhaft sind zylinderförmige Formen mit kreisförmigem, rechteckigem, quadratischem, dreieckigem oder vieleckigem Querschnitt bzw. Grundfläche. Der Begriff Zylinder wird hier in seiner allgemeinen geometrischen Bedeutung gebraucht und bezeichnet ein Volumen, das von zwei Flächen, welche vorzugsweise parallel und/oder eben sind (die Grund- und die Deckfläche) sowie von einer Mantel- bzw. Zylinderfläche begrenzt wird, wobei die Mantel- bzw. Zylinderfläche entlang der Ränder der Grund- und Deckfläche zwischen der Grund- und der Deckfläche umläuft. Die Mantel- bzw. Zylinderfläche wird hierbei vorzugsweise von parallelen Graden gebildet.

Der Durchmesser, die Höhe und/oder die Tiefe, der Kavitäten ist vorzugsweise ≥ 30 µm, besonders bevorzugt ≥ 50 µm, besonders bevorzugt ≥ 70 µm und/oder ≤ 500 µm, besonders bevorzugt ≥ 300 µm, besonders bevorzugt ≤ 110 µm, besonders bevorzugt ≤ 100 µm, besonders bevorzugt ≤ 90 µm, besonders bevorzugt ≤ 80 µm.

Die Kavitäten können beispielsweise hergestellt werden durch Micro-Electrodischarge-Machining (µEDM) oder durch Schneiden mittels eines Lasers. Die unterschiedlichen Schichten des Plasmastempels können beispielsweise durch Kleben oder mittels klebstofffreier Verfahren miteinander verbunden werden.

Die genannte Kavitätsschicht kann aus einer Vielzahl von Materialien hergestellt sein. Insbesondere sind Dielektrika wie Keramiken, Polymere, Photoresist-Materialien, Photolacke und/oder Metalle vorteilhaft. Die Kavitätsschicht kann beispielsweise auf eine angrenzende Schicht auflaminiert werden.

Das poröse Material der Gasleitschicht kann vorteilhafterweise ein poröses metallisches Material sein, sowie auch gesinterte Metallfasern oder gesintertes Pulver, insbesondere gesintertes Metallpulver. Auch können metallische Netze oder mehrere Lagen metallischer Netze verwendet werden. Metallische Materialien sind insbesondere dann vorteilhaft, wenn die Gasleitschicht als Elektrode dient. Als Metalle kommen beispielsweise Edelstähle, Nickel, Kupfer, Aluminium und Chrom-Nickel-Legierungen infrage.

Die Dicke der Kavitätsschicht ist vorzugsweise größer oder gleich 0,02 mm, besonders bevorzugt größer oder gleich 0,05 mm, besonders bevorzugt größer oder gleich 1 mm. Die Dicke der Kavitätsschicht ist außerdem vorzugsweise ≤ 2 mm, besonders bevorzugt ≤ 1,5 mm.

Die Gasleitschicht hat vorzugsweise eine Dicke von ≥ 0,2 mm, besonders bevorzugt ≥ 0,5 mm, besonders bevorzugt ≥ 1 mm. Die Dicke der Gasleitschicht ist auβerdem vorzugsweise ≤ 4 mm, besonders bevorzugt ≤ 3 mm, besonders bevorzugt ≤ 2 mm. Unter der Dicke der Kavitätsschicht bzw. der Gasleitschicht wird hier die Ausdehnung der entsprechenden Schicht in Richtung senkrecht zur Unterseite und damit auch senkrecht zur flächigen Ausdehnung der entsprechenden Schicht verstanden.

Die Plasmabehandlung ist besonders vorteilhaft durchführbar, wenn in der oder den Kavitäten ein Druck von ≥ 0,001 bar, vorzugsweise ≥ 0,01 bar, vorzugsweise ≥ 0,1 bar, vorzugsweise ≥ 0,5 bar erzeugbar ist. Der entsprechende Druck ist außerdem vorzugsweise ≤ 10 bar, besonders bevorzugt ≤ 5 bar, besonders bevorzugt ≤ 1,5 bar.

In den Kavitäten kann ein Plasma erzeugt werden. Vorzugsweise wird eine Hochfrequenzentladung mit einer Frequenz von beispielsweise 13,56 MHz, oder aber auch eine Mittelfrequenzentladung mit einer Frequenz vorzugsweise größer oder gleich 5 kHz, besonders bevorzugt größer oder gleich 20 kHz, besonders bevorzugt größer oder gleich 40 kHz und/oder kleiner oder gleich 100 kHz, vorzugsweise kleiner oder gleich 80 kHz, besonders bevorzugt kleiner oder gleich 60 kHz erzeugt. Man spricht bei Mittelfrequenzentladungen auch von transienten Gasentladungen, weil sie in jeder Halbwelle wieder erlöschen und neu zünden.

Je nach Anwendung kann das Plasma vorzugsweise so erzeugt werden bzw. erzeugbar sein, dass die Gasentladung sehr aktive Teilchen, wie beispielsweise hochenergetische Elektronen, Ionen, Photonen, Atome, Radikale usw. enthält, die es erlauben, auch bei relativ niedrigen Temperaturen auch vergleichsweise reaktionsträge Materialien zu modifizieren. Modifizierte Materialien können im Rahmen der vorliegenden Erfindung beispielsweise elektrische Isolatoren, Polymere, Glas, Keramiken oder Metalle sein. Eine Modifikation kann in einer chemischen und/oder physikalischen Veränderung bestehen, es kann aber auch eine Entfernung von Material von der Oberfläche oder eine Beschichtung der Oberfläche mit Material sein. Besonders für eine Beschichtung mit Material ist die vorliegende Erfindung vorteilhaft. Polymeroberflächen können beispielsweise anoxidiert und damit benetzbar gemacht werden, indem Polymere oxidativ oder mit Ionenbeschuss abgetragen werden. Metalle können oxidiert oder gesputtert werden. Eine Modifikation kann auch eine Änderung der chemischen Struktur der Oberfläche sein, so z.B. das Aufbringen bestimmter funktioneller Gruppen bei Polymeren, wie z,.B. Polytetrafluorethylen (PTFE). Die Modifikation kann auch in einer Schichtabscheidung bestehen, in welcher eine Änderung physikalischer Größen der Oberfläche, wie beispielsweise der Oberflächenleitfähigkeit oder der Oberflächenspannung bewirkt wird. Die Erfindung kann auch im Bereich des Plasmadruckens Verwendung finden.

Erfindungsgemäß kann als Gas unter anderem Edelgase, Sauerstoff, Stickstoff (auch im Gemisch mit Wasserstoff), Luft und/oder Ammoniak insbesondere für die Oberflächenmodifizierung verwendet werden. Unter anderem können auch fluorhaltige Gase zum Ätzen bzw. Abtragen von Oberflächen verwendet werden. Für eine Beschichtung können beispielsweise Kohlenwasserstoffe, Fluorkohlenwasserstoffe, Silane, Organosilane, Kieselsäureester, Hexamethyldisilan (HMDS), Hexamethyldisiloxan (HMSO), Hexamethyldisilazan (HMDSN), Tetramethylsilan (TMS) sowie flüchtige ungesättigte radikalisch polymerisierbare Verbindungen wie z.B. Acrylate, Methacrylate, Maleinsäureanhydrid und/oder Vinylverbindungen verwendet werden.

Die vorliegende Erfindung ist auch zur kombinatorischen Forschung im Bereich plasmabasierter Oberflächentechnologie oder Oberflächenchemie einsetzbar. Hierzu kann der Plasmastempel zumindest zwei Kavitäten aufweisen, welche vorzugsweise in einem Array angeordnet sind. In dem Plasmastempel kann nun zwischen den verschiedenen Kavitäten zumindest eine Eigenschaft der Plasmabehandlung verändert werden. Dies kann z.B. eine Eigenschaft des die Gasleitschicht durchströmenden Gases, eines Plasmas in den Kavitäten und/oder eine Eigenschaft des Plasmastempels selbst sein. Die mehreren Kavitäten sind vorzugsweise in einer Ebene angeordnet und die genannten Eigenschaften können vorzugsweise in einer oder zwei, vorzugsweise senkrecht aufeinander stehenden, Richtungen, in dieser Ebene verändert werden. Die Ebene, in welcher mehrere Kavitäten angeordnet sind, ist vorzugsweise die Ebene der Unterseite des Plasmastempels. Eigenschaften, die hierbei verändert werden können, sind beispielsweise eine Gasphasenkonzentration, eine Temperatur des Gases, eine Temperatur des Plasmas, eine Temperatur der Kavitätsschicht und/oder der Gasleitschicht, eine elektrische Feldstärke, ein Arbeitszyklusanteil, eine Behandlungsdauer oder auch eine Brenndauer des Plasmas. Die entsprechende Eigenschaft kann gezielt ortsabhängig eingestellt werden. Es kann aber auch ausgenutzt werden, dass sich die Eigenschaft aufgrund der Anordnung des Plasmastempels, seines Aufbaus oder aufgrund von Veränderungen durch die Plasmabehandlung selbst an unterschiedlichen Orten unterschiedlich einstellt. Ein Konzentrationsgradient kann beispielsweise eingestellt werden, indem Gas durch die Gasleitschicht über eine Vielzahl von Kavitäten geleitet wird. Wird nun in jeder der Kavitäten Gas verbraucht, so ergibt sich ein Konzentrationsgradient in Richtung des Gasflusses über die Kavitäten. Es kann auch in einer Richtung eine Eigenschaft verändert werden und in einer anderen, vorzugsweise hierzu senkrechten eine andere Eigenschaft. Es können auch zeilenweise ansprechbare Elektroden zum Einsatz kommen, so dass elektrische Größen für unterschiedliche Kavitäten unterschiedlich eingestellt werden können. Dies kann beispielsweise eine elektrische Feldstärke sein. Mit einer solchen Anordnung können auf der zu behandelnden Oberfläche Bereiche erzeugt werden, die mit unterschiedlichen Eigenschaften plasmabehandelt wurden.

Eine solche Anordnung ermöglicht die Realisierung kombinatorischer Methoden, welche den experimentellen Aufwand, welcher oft notwendig ist, um optimale Bedingungen für plasmabasierte Oberflächentechnologien zu bestimmen, vermindern. Ein Beispiel ist die Optimierung der Gaszusammensetzung und der Behandlungsparameter, um maximale Anhaftung einer Beschichtung auf einem Substrat zu erzielen. Viele andere Möglichkeiten sind vorstellbar, wie beispielsweise Oberflächenspannungsgradienten oder Gradienten in der Dichte funktionaler Gruppen. In Verbindung mit ortsaufgelösten Oberflächencharakterisierungsverfahren ist die Untersuchung von Plasma-Oberflächeninteraktionen deutlich vereinfachbar.

Der Plasmastempel kann beispielsweise in einem plasmachemischen Prozess nach einer Anzahl von Verwendungen gereinigt werden. Hierzu ist es bevorzugt, wenn der Plasmastempel aus Metall hergestellt ist.

Der beschriebene Plasmastempel kann in einer Plasmabehandlungsvorrichtung zum Einsatz kommen. Eine solche Plasmabehandlungsvorrichtung weist dann zumindest eine Elektrode auf, welche so unter der Unterseite des Plasmastempels angeordnet ist, dass zwischen dieser Elektrode und der Unterseite des Plasmastempels ein zu behandelndes Substrat bzw. eine zu behandelnde Oberfläche anordenbar ist. Das zu behandelnde Substrat wird also auf der Elektrode angeordnet und dann darüber der Plasmastempel. Vorzugsweise ist zwischen der Elektrode und der Unterseite des Plasmastempels ein Trägersubstrat so angeordnet, dass das zu beschichtende Substrat zwischen dem Trägersubstrat und der Unterseite des Plasmastempels anordenbar ist. Das Trägersubstrat ist dann also über der Elektrode angeordnet. Vorteilhafterweise weist das Trägersubstrat Glas auf oder besteht daraus, wobei besonders bevorzugt ist, dass das Trägersubstrat eine Glasschicht ist, die mit einer ITO (Indium-Zinnoxid)-Schicht auf jener der Unterseite des Plasmastempels abgewandten Seite beschichtet ist. Diese ITO-Schicht kann als Elektrode dienen.

Mit dem erfindungsgemäßen Plasmastempel und der erfindungsgemäßen Plasmabehandlungsvorrichtung ist auch ein Verfahren zur Plasmabehandlung von Oberflächen durchführbar, wobei einer Kavität in einem Plasmastempel, welche eine Öffnung zu einer Unterseite des Plasmastempels hat, über eine Gasleitschicht, welche zumindest ein poröses Material aufweist oder daraus besteht, Gas durch einen Gasfluss im Wesentlichen parallel zur Öffnung der Kavität zugeführt wird.

Im Folgenden sollen noch einige vorteilhafte Ausgestaltungen der Erfindung genannt werden:
Im erfindungsgemäßen Plasmastempel kann die Gasleitschicht parallel zur Kavitätsschicht auf der Kavitätsschicht angeordnet sein und vorzugsweise unmittelbar auf der Kavitätsschicht angeordnet sein.

Die gasundurchlässige Schicht kann vorzugsweise eine Öffnung zur Gaszuleitung und/oder eine Öffnung zur Gasableitung aufweisen.

Die Kavität kann zylinderförmig mit kreisförmigem, rechteckigem, quadratischem, dreieckigem oder vieleckigem Querschnitt oder Grundfläche sein.

Die Kavitätsschicht kann zumindest ein Material ausgewählt aus der Gruppe aufweisend ein Dielektrikum, Keramik, Polymer, ein Photoresist-Material und Metall aufweisen oder daraus bestehen.

Das poröse Material kann ein poröses metallisches Material, gesinterte Metallfasern, gesintertes Pulver, vorzugsweise gesintertes Metallpulver, eine oder mehrere Lagen metallischer Netze aufweisen oder sein, wobei vorzugsweise das offene Porenvolumen ≥ 30 %, vorzugsweise ≥ 50 %, vorzugsweise ≥ 60 %, vorzugsweise ≥ 80 %, vorzugsweise ≥ 90 %, vorzugsweise ≥ 95 % ist, und wobei vorzugsweise das Metall Edelstahl, Nickel, Kupfer, Aluminium, Cr-Nickel-Legierungen aufweist oder darin besteht.

Die Dicke der Kavitätsschicht kann vorzugsweise ≥ 0,02 mm, vorzugsweise ≥ 0,05 mm, vorzugsweise ≥ 1 mm sein und/oder die Dicke der Kavitätsschicht kann vorzugsweise ≤ 2 mm, vorzugsweise ≤ 1,5 mm sein. Die Dicke der Gasleitschicht kann bevorzugt ≥ 0,2 mm, vorzugsweise ≥ 0,5 mm, vorzugsweise ≥ 1 mm sein und/oder die Dicke der Gasleitschicht kann vorzugsweise ≤ 4 mm, vorzugsweise ≤ 3 mm, vorzugsweise ≤ 2 mm sein.

In der Kavität kann ein Druck von ≥ 0,001 bar, vorzugsweise ≥ 0,01 bar, vorzugsweise ≥ 0,1 bar, vorzugsweise ≥ 0,5 bar erzeugbar sein und/oder in der Kavität kann vorzugsweise ein Druck von ≤ 10 bar, vorzugsweise ≤ 5 bar, vorzugsweise ≤ 1,5 bar erzeugbar sein.

In der Kavität kann ein Plasma, vorzugsweise eine kalte Wechselstrom-Gasentladung oder eine transiente Gasentladung erzeugbar sein.

Mit dem erfindungsgemäßen Plasmastempel kann bevorzugt eine Plasmabeschichtung, eine Abtragung, eine Oberflächenreinigung und/oder eine Oberflächenmodifizierung, vorzugsweise eine Oberflächenmodifizierung mit Luft, Sauerstoff und/oder stickstoffhaltigen Gasen bewirkbar sein.

Die erfindungsgemäße Plasmabehandlungsvorrichtung kann dadurch gekennzeichnet sein, dass das Trägersubstrat Glas aufweist oder daraus besteht, vorzugsweise dass das Trägersubstrat Glas mit einer ITO-Schicht auf jener der Unterseite des Plasmastempels abgewandten Seite aufweist oder ist.

Im Folgenden soll die Erfindung anhand einiger Figuren beispielhaft erläutert werden. Die in den Figuren gezeigten Merkmale können auch einzeln erfindungsgemäß realisiert sein.

Es zeigt
- Figur 1: eine erste Ausführungsform eines erfindungsgemäßen Plasmastempels,
- Figur 2: eine zweite Ausführungsform eines erfindungsgemäßen Plasmastempels,
- Figur 3: eine Plasmabeschichtungsvorrichtung gemäß der vorliegenden Erfindung und
- Figur 4: eine weitere erfindungsgemäße Plasmabeschichtungsvorrichtung.

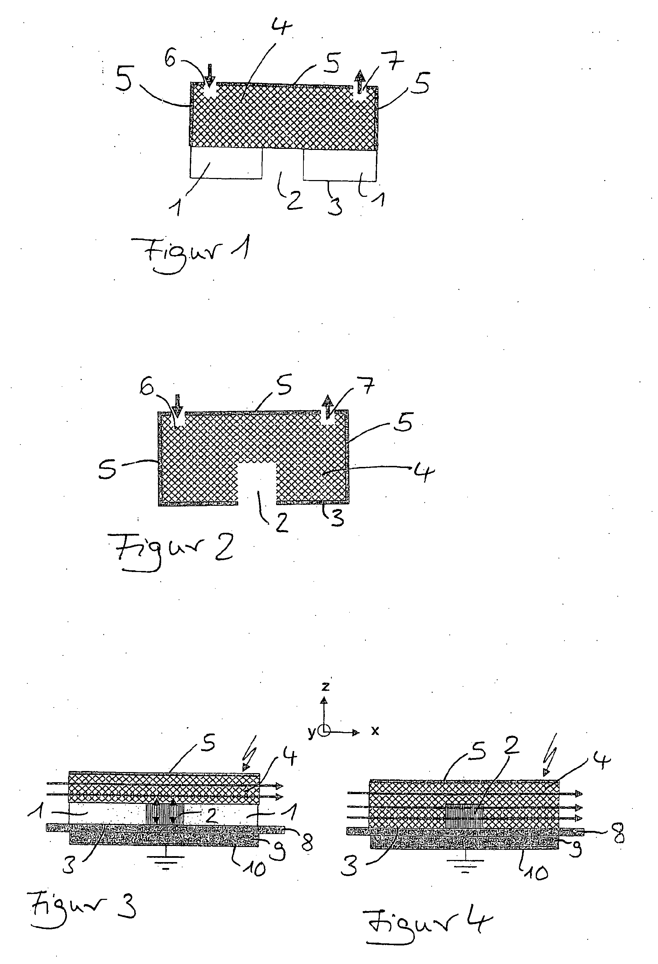

Figur 1 zeigt einen erfindungsgemäßen Plasmastempel. Der Plasmastempel weist eine Kavitätsschicht 1 auf, in welcher eine zylindrische Kavität 2 eingebracht ist. Die Kavität 2 weist eine Öffnung in einer Unterseite 3 des Plasmastempels auf. Auf jener der Unterseite 3 des Plasmastempels abgewandten Seite der Kavitätsschicht 1 ist eine Gasleitschicht 4 angeordnet, die ein poröses Material aufweist. Die Gasleitschicht 4 ist auf ihrer der Kavitätsschicht 1 abgewandten Oberseite sowie ihren hierzu senkrechten Seitenflächen mit einer gasundurchlässigen Schicht 5 überzogen. In der gasundurchlässigen Schicht 5 ist auf der Oberseite der Gasleitschicht 4 eine Öffnung 6 zum Gaseinlass und durch die Öffnung 7 zum Gasauslass eingebracht. In diesem Plasmastempel kann also Gas durch die Öffnung 6 durch die gasundurchlässige Schicht 5 hindurch in die Gasleitschicht 4 eingeleitet werden und durch die Öffnung 7 aus der Gasleitschicht 4 ausgeleitet werden. In der Gasleitschicht 4 strömt das Gas im Bereich hinter der Kavität 2 im Wesentlichen parallel zur Fläche der Öffnung der Kavität in der Unterseite des Plasmastempels an der Kavität 2 vorbei. Hauptsächlich durch Diffusion gelangt hierbei Gas aus der Gasleitschicht 4 in die Kavität 2. Der gezeigte Plasmastempel kann mit seiner Unterseite 3 auf einem zu behandelnden Substrat angeordnet werden.

Die Kavitätsschicht 1 kann eine dielektrische Schicht sein. Diese erlaubt die Erzeugung eines sehr homogenen elektrischen Feldes in der Kavität, was eine gleichförmigere Verteilung der Entladung fördert. Alternativ kann als Kavitätsschicht auch eine laminierte Photoresistschicht verwendet werden. Die gezeigte Kavitätsschicht 1 kann beispielsweise auch eine Metallfolie von ungefähr 100 µm Dicke sein, die das entsprechende Kavitätsmuster trägt. Die Kavitäten können beispielsweise durch Micro-Electrodischarge-Machining (µEDM) oder durch Laserschneiden hergestellt sein. Die Folie kann beispielsweise durch einfaches Kleben oder durch klebstofffreie Verfahren an das poröse Material der Gasleitschicht gebondet werden. Die in Figur 1 gezeigte Kavität hat beispielsweise einen Durchmesser von 50 bis 100 µm und eine ähnliche Höhe. Ein rein metallisches Design hat den Vorteil, dass es deutlich stabiler gegenüber Plasma bei atmosphärischem Druck ist als ein Polymer.

Figur 2 zeigt eine weitere Ausführungsform eines erfindungsgemäßen Plasmastempels. Hier ist eine Kavität 2 in die Gasleitschicht 4 eingebracht. Die Kavität 2 ist nicht auf der gesamten Tiefe der Gasleitschicht 4 eingebracht, sondern nur bis zu einer bestimmten Tiefe. Wiederum ist die Gasleitschicht 4 durch eine undurchlässige Schicht 5 an deren Seitenflächen sowie an der Oberfläche und auch an der Unterseite 3 beschichtet.

An der Oberseite der Gasleitschicht 4, welche der Unterseite 3 abgewandt ist, ist eine Öffnung 6 zum Gaseinlass sowie eine Öffnung 7 zum Gasauslass eingebracht. Gas kann also durch die Öffnung 6 in die Gasleitschicht 4 und in den Plasmastempel eingeführt werden und aus der Öffnung 7 ausgeführt werden. In der Gasleitschicht 4 strömt das Gas im Bereich hinter der Öffnung der Kavität 2 einerseits wie oben beschrieben an der Kavität 4 vorbei, andererseits aber auch direkt durch die Kavität 4. Gas wird hier also auch konvektiv in die Kavität 4 eingebracht.

Figur 3 zeigt nun eine Plasmabeschichtungsvorrichtung gemäß der vorliegenden Erfindung. In der gezeigten Plasmabeschichtungsvorrichtung ist ein Plasmastempel mit einer gasundurchlässigen Schicht 5, einer Gasleitschicht 4 und einer Kavitätsschicht 1 auf einem zu beschichteten Substrat 8 angeordnet, welches seinerseits auf einer Glasplatte 9, die auf ihrer dem zu beschichteten Substrat 8 abgewandten Seite mit einer leitfähigen Schicht 10 aus Indium-Zinnoxid (ITO) beschichtet ist, angeordnet. Die leitfähige Indium-Zinnoxidschicht 10 dient hier als Elektrode. Im gezeigten Beispiel ist nur die der Unterseite 3 des Plasmastempels abgewandten Oberseite des Plasmastempels mit einer gasundurchlässigen Schicht 5 beschichtet. Diese gasundurchlässige Schicht 5 dient hierbei außerdem als Elektrode 5. Die gasundurchlässige Schicht 5, die Gasleitschicht 4, die Kavitätsschicht 1, das zu beschichtende Substrat, das Trägersubstrat 9 sowie die Elektrode 10 sind im gezeigten Beispiel parallel zueinander angeordnet. Gas kann nun parallel zur Elektrode 5 durch die Gasleitschicht 4 geleitet werden. Hauptsächlich durch Diffusion gelangt dann Gas in die Kavität 2. Durch Anlegen einer elektrischen Spannung zwischen den Elektroden 5 und 10 kann in der Kavität 2 ein Plasma erzeugt werden, mit welchem die Oberfläche 8 behandelt werden kann.

Figur 4 zeigt eine weitere Ausführungsform einer erfindungsgemäßen Plasmabeschichtungsvorrichtung. Gleiche Bezugszeichen entsprechen hierbei entsprechenden Merkmalen wie in den anderen Figuren. Die in Figur 4 gezeigte Ausführungsform weist keine Kavitätsschicht 1 auf. Vielmehr ist die Kavität 2 in die Gasleitschicht 4 eingebracht. Wiederum ist auch auf jener der Unterseite 3 angewandten Oberseite der Gasleitschicht 4 eine gasundurchlässige Schicht 5 angeordnet, welche im gezeigten Beispiel als flächige Elektrode dient. Gas kann nun von den Seitenwänden der Gasleitschicht 4 durch diese hindurch geleitet werden und durchströmt einerseits die Kavität 2, strömt aber auch oberhalb der Kavität 2 an dieser vorbei. Gastransport in die Kavität findet hier hauptsächlich konvektiv statt. Wiederum wird das Plasma in der Kavität 2 durch Anlegen einer Spannung zwischen den Elektroden 5 und 10 erzeugt.

Eine erfindungsgemäße Plasmabeschichtungsvorrichtung kann beispielsweise wie folgt hergestellt werden. Eine poröse, aus Metallfasern von im Mittel 50 µm Durchmesser hergestellte Sintermetallplatte von 1 mm Dicke und einer Fläche von 50x50 mm² als Gasleitschicht wird von einer Seite (Oberseite) mit einer 125 µm dicken Edelstahlfolie als gasundurchlässige Schicht und von der anderen Seite (Unterseite) mit einer ebenfalls 125 µm dicken Edelstahlfolie als Kavitätsschicht beklebt. In die auf der Unterseite aufgebrachte Edelstahlfolie werden zylindrische Bohrungen als Kavitäten von 500 µm Durchmesser eingebracht. Es werden beispielsweise 100 Bohrungen auf einem quadratischen Gitter mit Mittenabständen von 2 mm eingebracht. Die Kanten werden mit einem Klebstoff verschlossen. Anschließend werden in die Oberseite in der unmittelbaren Nähe der Ränder der Oberseite, welche hier eine quadratische Platte ist, zwei parallele, 40 mm lange, 1 mm breite Schlitze als Gaszu- bzw. -abfuhr gefräst, so dass die Platte über eine Länge von etwa 45 mm von Gas durchströmt werden kann.

Eine Beschichtung eines Substrats kann dann beispielsweise wie folgt durchgeführt werden. Ein Gasgemisch bestehend aus 1 % Tetramethyl-Orthosilikat in einer Mischung von 19 % Sauerstoff und 80 % Helium wird unter einem Vordruck von 0,1 bar durch die Anordnung geleitet. Die Kavitätsschicht wird mit ihrer Unterseite auf eine 75 µm dicke Polyethylenfolie gedrückt. Unterhalb der Polyethylenfolie wird als Gegenelektrode eine ITO-beschichtete Glasscheibe angeordnet. An die Elektroden wird eine Hochspannung von ca. 30 kHz angelegt. Die Spannung wird dann bis zur Zündung einer Entladung bei ca. 6,5 kV (Amplitude) gesteigert.

Nach einer Einwirkungszeit der Entladung von 10 s wird eine Polymeroberfläche mittels ATR-IR-Spektroskopie und profilometrisch untersucht. SiO₂ wird anhand seiner starken IR-Absorption bei 1060 cm⁻¹ erkannt. Die Schichtdicke der kreisförmigen Abscheidungen beträgt im Mittel 30 nm.

## Patentansprüche

1. Plasmastempel mit einer Gasleitschicht (4), welche zumindest ein poröses Material aufweist oder daraus besteht, sowie mit zumindest einer Kavität (2), welche mit der Gasleitschicht (4) in gasdurchlässiger Verbindung steht und welche eine Öffnung zu einer Unterseite (3) des Plasmastempels aufweist, wobei Gas im Bereich hinter der Öffnung der Kavität (2) in Richtung im Wesentlichen parallel zur Fläche der Öffnung durch die Gasleitschicht (4) leitbar ist, wobei die Kavität (2) in einer Kavitätsschicht (1) angeordnet ist, wobei sich die Kavität (2) bis auf eine Oberseite der Kavitätsschicht (1) erstreckt sowie bis auf eine der Oberseite gegenüberliegende Unterseite der Kavitätsschicht (1), wobei die Gasleitschicht (4) auf der Oberseite der Kavitätsschicht (1) an die Kavität (2) grenzt, **gekennzeichnet durch** eine gasundurchlässige Schicht (5) auf jener der Unterseite des Plasmastempels abgewandten Seite der Gasleitschicht.

2. Plasmastempel nach dem vorhergehenden Anspruch, **dadurch gekennzeichnet, dass** das Gas der Kavität (2) über die Gasleitschicht (4) zuführbar und/oder aus der Kavität (2) ableitbar ist.

3. Plasmastempel nach einem der vorhergehenden Ansprüche, **dadurch gekennzeichnet, dass** die Kavität (2) in der Gasleitschicht (4) angeordnet ist.

4. Plasmastempel nach einem der Ansprüche 1 oder 2, **dadurch gekennzeichnet, dass** die Unterseite der Kavitätsschicht mit der Unterseite (3) des Plasmastempels zusammenfällt.

5. Plasmastempel nach dem vorhergehenden Anspruch, **dadurch gekennzeichnet, dass** das Gas in Richtung parallel zur Fläche der Oberseite der Kavitätsschicht (1) an der Kavität (2) vorbei durch die Gasleitschicht (4) leitbar ist, vorzugsweise zumindest teilweise unmittelbar an der Kavität (2) vorbei durch die Gasleitschicht (4) leitbar ist.

6. Plasmastempel nach einem der vorhergehenden Ansprüche, **gekennzeichnet durch** eine gasundurchlässige Schicht auf zumindest einer Oberfläche des Plasmastempels zwischen einer Oberseite des Plasmastempels und der Unterseite des Plasma-stempels und/oder auf der Unterseite des Plasmastempels.

7. Plasmastempel nach einem der vorhergehenden Ansprüche, **dadurch gekennzeichnet, dass** eine Elektrode auf einer der Unterseite abgewandten Oberseite des Plasmastempels oder auf jener der Unterseite des Plasmastempels abgewandten Seite der Gasleitschicht (4) angeordnet ist und/oder dass eine Elektrode auf jener der Gasleitschicht (4) abgewandten Seite der gasundurchlässigen Schicht angeordnet ist und/oder dass die gasundurchlässige Schicht eine Elektrode ist oder dass die Gasleitschicht (4) eine Elektrode ist.

8. Plasmastempel nach einem der vorhergehenden Ansprüche, **gekennzeichnet durch** zumindest zwei Kavitäten (2), die vorzugsweise in einem Array angeordnet sind, wobei zumindest eine Eigenschaft des die Gasleitschicht (4) durchströmenden Gases, eines Plasmas in den Kavitäten (2) und/oder zumindest eine Eigenschaft des Plasmastempels in einer oder zwei, vorzugsweise senkrecht zueinander stehenden, Richtungen parallel zur Unterseite des Plasmastempels veränderbar und/oder einstellbar ist, wobei vorzugsweise die Eigenschaft zumindest eine Eigenschaft ausgewählt aus der Gruppe aufweisend eine Gasphasenkonzentration, eine Temperatur des Gases, eine Temperatur des Plasmas, eine Temperatur der Kavitätsschicht, eine Temperatur der Gasleitschicht, eine elektrische Feldstärke, ein Arbeitszyklusanteil, eine Behandlungsdauer und eine Brenndauer des Plasmas ist.

9. Plasmabehandlungsvorrichtung mit zumindest einem Plasmastempel nach einem der vorhergehenden Ansprüche sowie mit zumindest einer Elektrode, welche so unter der Unterseite (3) des Plasmastempels angeordnet ist, dass zwischen der Elektrode und der Unterseite (3) des Plasmastempels ein zu behandelndes Substrat (8) anordenbar ist.

10. Plasmabehandlungsvorrichtung nach dem vorhergehenden Anspruch, **gekennzeichnet durch** zumindest ein Trägersubstrat (9) zwischen der Elektrode unter der Unterseite und der Unterseite des Plasmastempels, welches so angeordnet ist, dass zwischen dem Trägersubstrat (9) und der Unterseite des Plasmastempels das zu behandelnde Substrat (8) anordenbar ist.

11. Verfahren zur Plasmabehandlung von Oberflächen, wobei einer Kavität in einem Plasmastempel, welche eine Öffnung zu einer Unterseite des Plasmastempels hat, über eine Gasleitschicht, die zumindest ein poröses Material aufweist oder daraus besteht, Gas durch einen Gasfluss im Wesentlichen parallel zu der Öffnung der Kavität zugeführt wird,
wobei der Plasmastempel ein Plasmastempel nach einem der Ansprüche 1 bis 8 ist.

12. Verfahren nach dem vorhergehenden Anspruch, **dadurch gekennzeichnet, dass** das Verfahren in einer Plasmabehandlungsvorrichtung nach einem der Ansprüche 9 oder 10 durchgeführt wird.

13. Verfahren zur Herstellung eines Plasmastempels, wobei eine Kavität, welche eine Öffnung zu einer Unterseite des Plasmastempels aufweist, hergestellt wird, und wobei eine Gasleitschicht aus zumindest einem porösen Material hergestellt wird, wobei die Kavität und die Gasleitschicht so hergestellt werden, dass die Kavität mit der Gasleitschicht in gasdurchlässiger Verbindung steht, und dass die Kavität eine Öffnung in einer Unterseite des Plasmastempels aufweist, und dass Gas im Bereich hinter der Öffnung der Kavität im Wesentlichen parallel zur Fläche der Öffnung durch die Gasleitschicht leitbar ist,
**dadurch gekennzeichnet, dass** ein Plasmastempel nach einem der Ansprüche 1 bis 8 hergestellt wird.

14. Verfahren nach dem vorhergehenden Anspruch, **dadurch gekennzeichnet, dass** die zumindest eine Kavität mittels eines Laserstrahls eingebracht wird.

## Claims

1. Plasma stamp having a gas conducting layer (4), which has at least one porous material or consists thereof, as well as having at least one cavity (2), which is in gas-permeable contact with the gas conducting layer (4) and which has an opening towards an underside (3) of the plasma stamp, wherein gas in the region behind the opening of the cavity (2) can be conducted through the gas conducting layer (4) in a direction that is substantially parallel to the surface of the opening, wherein the cavity (2) is arranged in a cavity layer (1), wherein the cavity (2) extends up to an upper side of the cavity layer (1) and up to an underside of the cavity layer (1) that is located opposite the upper side, wherein the gas conducting layer (4) touches the cavity (2) on the upper side of the cavity layer (1), **characterised by** a non-gas-permeable layer (5) on the side of the gas conducting layer that is facing away from the underside of the plasma stamp.

2. Plasma stamp according to the preceding claim,
**characterised in that** the gas can be supplied to the cavity (2) via the gas conducting layer (4) and/or can be discharged from the cavity (2).

3. Plasma stamp according to one of the preceding claims, **characterised in that** the cavity (2) is arranged in the gas conducting layer (4).

4. Plasma stamp according to one of claims 1 or 2, **characterised in that** the underside of the cavity layer concurs with the underside (3) of the plasma stamp.

5. Plasma stamp according to the preceding claim,
**characterised in that** the gas can be conducted through the gas conducting layer (4) past the cavity (2) in a direction parallel to the surface of the upper side of the cavity layer (1), and can preferably be conducted through the gas conducting layer (4) at least partially directly past the cavity (2).

6. Plasma stamp according to one of the preceding claims, **characterised by** a gas-impermeable layer on at least one surface of the plasma stamp between an upper side of the plasma stamp and the underside of the plasma stamp and/or on the underside of the plasma stamp.

7. Plasma stamp according to one of the preceding claims, **characterised in that** an electrode is arranged on an upper side of the plasma stamp facing away from the underside or on the side of the gas conducting layer (4) that is facing away from the underside of the plasma stamp, and/or **in that** an electrode is arranged on the side of the non-gas-permeable layer that is facing away from the gas conducting layer (4) and/or **in that** the non-gas-permeable layer is an electrode or in that the gas conducting layer (4) is an electrode.

8. Plasma stamp according to one of the preceding claims, **characterised by** at least two cavities (2) that are preferably arranged in an array, wherein at least one property of the gas that flows through the gas conducting layer (4) or of a plasma in the cavities (2), and/or at least one property of the plasma stamp can be amended and/or adjusted in one or two directions that are preferably perpendicular to each other and are parallel to the underside of the plasma stamp, wherein the property is preferably at least one property selected from the group having a gas phase concentration, a temperature of the gas, a temperature of the plasma, a temperature of the cavity layer, a temperature of the gas conducting layer, an electrical field strength, an operating cycle proportion, a treatment duration and a burning period of the plasma.

9. Plasma treatment device having at least one plasma stamp according to one of the preceding claims, as well as having at least one electrode, which is arranged beneath the underside (3) of the plasma stamp in such a way that a substrate (8) that is to be treated can be arranged between the electrode and the underside (3) of the plasma stamp.

10. Plasma treatment device according to the preceding claim, **characterised by** at least one carrier substrate (9) between the electrode beneath the underside and the underside itself of the plasma stamp, said carrier substrate being arranged in such a way that the substrate (8) that is to be treated can be arranged between the carrier substrate (9) and the underside of the plasma stamp.

11. Method for the plasma treatment of surfaces, wherein a cavity in a plasma stamp, which has an opening towards an underside of the plasma stamp, is supplied with gas by a gas flow that is substantially parallel to the opening of the cavity via a gas conducting layer having at least one porous material or consisting thereof,
wherein the plasma stamp is a plasma stamp according to one of claims 1 to 8.

12. Method according to the preceding claim, **characterised in that** the method is carried out in a plasma treatment device according to one of claims 9 or 10.

13. Method for the production of a plasma stamp, wherein a cavity, which has an opening towards an underside of the plasma stamp, is produced, and wherein a gas conducting layer is produced from at least one porous material, wherein the cavity and the gas conducting layer are produced in such a way that the cavity is in a gas-permeable connection with the gas conducting layer, and that the cavity has an opening in an underside of the plasma stamp, and that gas in the region behind the opening of the cavity can be conducted through the gas conducting layer substantially parallel to the surface of the opening,
**characterised in that** a plasma stamp according to one of claims 1 to 8 is produced.

14. Method according to the preceding claim, **characterised in that** the at least one cavity is inserted by means of a laser beam.

## Revendications

1. Poinçon à plasma comprenant une couche conductrice de gaz (4), qui présente au moins un matériau poreux ou qui est constituée dudit matériau poreux, comprenant également au moins une cavité (2) qui est reliée à la couche conductrice de gaz (4) de manière perméable aux gaz et qui présente une ouverture menant à un côté inférieur (3) du poinçon à plasma, le gaz pouvant être acheminé, dans la zone située derrière l'ouverture de la cavité (2), de manière sensiblement parallèle à la face de l'ouverture, par la couche conductrice de gaz (4), la cavité (2) étant disposée dans une couche de cavité (1), la cavité (2) s'étendant jusqu'à un côté supérieur de la couche de cavité (1) ainsi que jusqu'à un côté inférieur, faisant face au côté supérieur, de la couche de cavité (1), la couche conductrice de gaz (4) jouxtant la cavité (2) sur le côté supérieur de la couche de cavité (1), **caractérisé par** une couche imperméable aux gaz (5) sur le côté de la couche conductrice de gaz opposé au côté inférieur du poinçon à plasma,.

2. Poinçon à plasma selon la revendication précédente, **caractérisé en ce que** le gaz peut être amené à la cavité (2) par l'intermédiaire de la couche conductrice de gaz (4) et/ou peut être évacué de la cavité (2).

3. Poinçon à plasma selon l'une quelconque des revendications précédentes, **caractérisé en ce que** la cavité (2) est disposée dans la couche conductrice de gaz (4).

4. Poinçon à plasma selon l'une quelconque des revendications 1 ou 2, **caractérisé en ce que** le côté inférieur de la couche de cavité coïncide avec le côté inférieur (3) du poinçon à plasma.

5. Poinçon à plasma selon la revendication précédente, **caractérisé en ce que** le gaz peut être acheminé parallèlement à la face du côté supérieur de la couche de cavité (1), le long de la cavité (2), par la couche conductrice de gaz (4), peut être acheminé de préférence au moins en partie directement le long de la cavité (2) par la couche directrice de gaz (4).

6. Poinçon à plasma selon l'une quelconque des revendications précédentes, **caractérisé par** une couche imperméable aux gaz sur au moins une surface supérieure du poinçon à plasma entre un côté supérieur du poinçon à plasma et le côté inférieur du poinçon à plasma et/ou sur le côté inférieur du poinçon à plasma.

7. Poinçon à plasma selon l'une quelconque des revendications précédentes, **caractérisé en ce qu'**une électrode est disposée sur un côté supérieur, opposé au côté inférieur, du poinçon à plasma ou sur le côté, opposé au côté inférieur du poinçon à plasma, de la couche conductrice de gaz (4), et/ou **en ce qu'**une électrode est disposée sur le côté, opposé à la couche conductrice de gaz (4), de la couche imperméable aux gaz, et/ou **en ce que** la couche imperméable aux gaz est une électrode, ou **en ce que** la couche conductrice de gaz (4) est une électrode.

8. Poinçon à plasma selon l'une quelconque des revendications précédentes, **caractérisé par** au moins deux cavités (2) qui sont disposées de préférence dans un réseau, au moins une propriété du gaz parcourant la couche conductrice de gaz (4), d'un plasma dans les cavités (2) et/ou au moins une propriété du poinçon à plasma pouvant être modifiées et/ou ajustées dans une ou deux directions, de préférence perpendiculaires l'une par rapport à l'autre, de manière parallèle par rapport au côté inférieur du poinçon à plasma, la propriété étant de préférence au moins une propriété choisie parmi le groupe présentant une concentration en phase gazeuse, une température du gaz, une température du plasma, une température de la couche de cavité, une température de la couche conductrice de gaz, une intensité de champ électrique, une partie de cycle de travail, une durée de traitement et une durée de combustion du plasma.

9. Dispositif de traitement au plasma comprenant au moins un poinçon à plasma selon l'une quelconque des revendications précédentes, comprenant également au moins une électrode, qui est disposée de telle façon sous le côté inférieur (3) du poinçon à plasma qu'un substrat (8) à traiter peut être disposé entre l'électrode et le côté inférieur (3) du poinçon à plasma.

10. Dispositif de traitement au plasma selon la revendication précédente, **caractérisé par** au moins un substrat de support (9) entre l'électrode sous le côté inférieur et le côté inférieur du poinçon à plasma, lequel substrat de support est disposé de telle manière que le substrat à traiter (8) peut être disposé entre le substrat de support (9) et le côté inférieur du poinçon à plasma.

11. Procédé servant à traiter au plasma des surfaces, sachant que du gaz est amené, par un flux de gaz, de manière sensiblement parallèle à l'ouverture de la cavité, à une cavité dans un poinçon à plasma, laquelle cavité étant pourvue d'une ouverture menant à un côté inférieur du poinçon à plasma, par l'intermédiaire d'une couche conductrice de gaz, qui présente au moins un matériau poreux ou qui est constituée d'au moins un matériau poreux,
le poinçon à plasma étant un poinçon à plasma selon l'une quelconque des revendications 1 à 8.

12. Procédé selon la revendication précédente, **caractérisé en ce que** le procédé est réalisé dans un dispositif de traitement au plasma selon l'une quelconque des revendications 9 ou 10.

13. Procédé servant à fabriquer un poinçon à plasma, une cavité étant fabriquée, qui présente une ouverture menant à un côté inférieur du poinçon à plasma, et une couche conductrice de gaz étant fabriquée à partir d'au moins un matériau poreux, la cavité et la couche conductrice de gaz étant fabriquées de telle manière que la cavité est reliée, de manière perméable aux gaz, à la couche conductrice de gaz, que la cavité présente une ouverture dans un côté inférieur du poinçon à plasma et que le gaz peut être acheminé, dans la zone située derrière l'ouverture de la cavité, de manière sensiblement parallèle à la face de l'ouverture, par la couche conductrice de gaz,
**caractérisé en ce qu'**un poinçon à plasma est fabriqué selon l'une quelconque des revendications 1 à 8.

14. Procédé selon la revendication précédente, **caractérisé en ce que** la cavité au moins au nombre de une est pratiquée au moyen d'un rayon laser.
